# EUROPEAN PATENT APPLICATION

(11) **EP 0 750 056 A1**
(43) Date of publication of application: **27.12.1996**
(21) Application number: 96830340.4
(22) Date of filing: 14.06.1996
(51) Int. Cl.: C23C 14/00, C23C 14/56

(54) **Continuous vacuum evaporation system**

(30) Priority: 19.06.1995 IT FI950136
(71) Applicant: GALILEO VACUUM TEC S.p.A., 50047 Prato (IT)
(72) Inventor: Fusi, Andrea, 50136 Firenze (IT)
(74) Representative: Mannucci, Gianfranco, Dott.-Ing.

(57) **Abstract**

In order to form deposits of AlOₓ or of anothermetal oxide on plastic films, vapours of the component substances of the layer to be deposited and a gas such as oxygen or an oxygen-containing gas are introduced, which gas collides with the flow of vapours directed upon the film on which they are to condense; for the introduction of the gas, ionizers are provided which introduce the gas predominantly in the form of plasma generated in hollow cathodes.

## Description

In the technology of the vacuum deposition of thin layers of a glassy nature, and in particular of oxides of aluminium or another metal, on plastic films or the like, the system of injecting an oxygen-containing gas associated with generators of Al vapours (see E.P. A 437,946 A₂) for creating a coating with a predominant presence of oxides is already known. The oxygen emitters are normal jets positioned in the flow of the vapours and mostly oriented in the same direction as the vapours towards the surface on which the oxide deposit is to be formed.

Other solutions use a system comprising vapour generators, oxygen injection, means for generating magnetic fields in the space traversed by the vapours and by the oxygen, and an energizing complex with a plasma curtain generated from argon and traversed by the flow of the vapours and the oxygen (Fraunhofer Institute, Dresden-374 Ann. Techn. Conference May 8-13, 1994, Boston MA-USA). This solution appears to be complicated and laborious.

The subject of the invention is equipment which turns out to be particularly efficacious for the formation of oxide deposits on plastic films and is particularly simple in its structure, providing for generation of vapours of the component substances of the layer to be deposited and for injection of a gas such as oxygen or an oxygen-containing gas, which gas collides with the flow of the vapours directed upon the film on which they are to condense. According to the invention, ionizing jets which inject the gas predominantly in the form of plasma are provided for the injection of the gas. These jets are in practice polarized as hollow cathodes which ionize the oxygen-containing gas which traverses them.

The oxygen-containing gas can be straight oxygen alone or oxygen plus Co₂ or another oxygen-containing gas.

The hollow cathodes are to be understood as polarized cavities whose walls confine the free electrons in the central zone, the electrons being repelled away from the walls; this facilitates the ionization of the gases which traverse the cavity of the cathode and move away from the latter.

In equipment comprising an array of vapour generators or crucibles, the ionizing jets with the hollow cathodes are interposed between the vapour generators and are oriented with their outlet towards the surface on which the deposit of oxides is to be formed. One or even two hollow cathodes aligned in the direction of motion of the substrate, on which the deposit of oxides is to be formed, may be disposed between neighbouring vapour generators.

Advantageously the plasma emerges from the jets at a certain height above the level of the generation of the aluminium vapours.

The hollow-cathode ionizing jets are generally energized by a radiofrequency system, but they can be energized by a d.c. system or pulsed d.c. system.

The invention will be better understood by following the description and the single drawing which shows a practical illustrative embodiment which does not limit the invention. In the drawing:
Figure 1 shows a diagram of the vacuum equipment in vertical section,
Figure 2 is a diagrammatic partial view on II-II in Figure 1, illustrating the vapour generators and the hollow-cathode ionizing jets for the generation of oxygen plasma,
Figure 3 shows an enlarged detail of Figure 1 and
Figure 4 shows a modified form of ionizing jet.

In the drawing, 1 indicates the high-vacuum chamber containing the drum 3 for the exposure of the film P which is to be treated and which is unwound from one of the rolls 5 and 7 and rewound on the other.

9 indicates the vapour generators in the form of tray crucibles which are heated in a conventional manner and fed by filaments 10 of the material to be vaporized -for example Al - for the formation of the deposits of the corresponding oxides; the generated vapours V reach the surface of the film P passing around the periphery of the drum 3 and exposed to the generators 9; a plurality of generators 9 are disposed in an array under the drum. Between the generators 9 of vapours of Al or another metal, hollow cathodes 12 are interposed which are polarized by a radiofrequency system or the like, capable of forming, from the oxygen being fed to them, a plasma P1 which is given off from the orifices 12A facing the drum 3.

The energized oxygen ions emitted from the cathodes 12 mix with the vapours emitted from the generators 9, and the resulting deposit forming on the passing film consists predominantly of oxides, such as oxides AlOₓ, symbolizing more or less complete oxidation of the substances emitted by the generators 9.

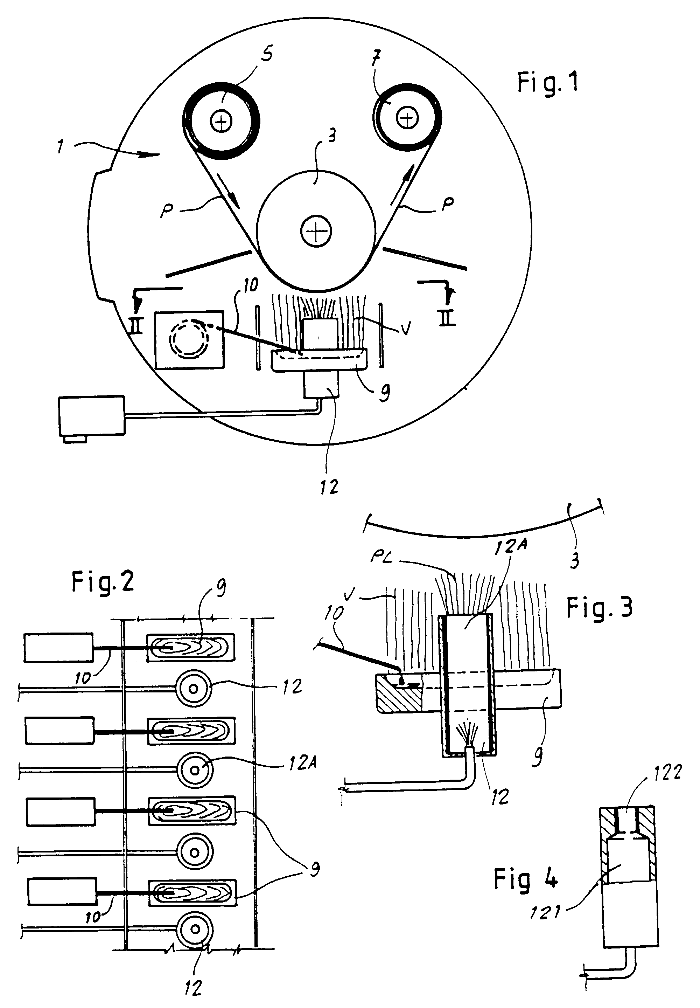

Figure 4 shows a form of ionizing jet which is particularly suitable and efficacious for the purposes of the invention. A relatively elongate outlet 122 of reduced cross-section extends upwards from the cavity 121 of the jet, and its wall forms the energized cathode.

The simple structure described makes it possible, surprisingly, to obtain particularly satisfactory results with regard to the properties required for the glassy deposits of the films.

It will be understood that the drawing shows only one example given solely as a practical demonstration of the invention, it being possible for this invention to vary in its forms and arrangements without thereby departing from the scope of the concept underlying the invention itself.

## Claims

1. Continuous equipment for the vacuum deposition of oxides of metals or the like, such as AlOₓ, with generation of vapours of the component substances of the layer to be deposited and with injection of a gas such as oxygen or an oxygen-containing gas, which gas collides with the flow of vapours directed upon the film on which they are to condense, characterized in that, for the injection of the gas, ionizing jets are provided which inject the gas predominantly in the form of plasma.

2. Equipment according to Claim 1, characterized in that the ionizing jets are negatively polarized, so that they assume the function of hollow cathodes which are traversed by oxygen or another oxygen-containing gas.

3. Equipment according to Claim 1 or 2, comprising an array of vapour generators or crucibles, characterized in that the ionizing jets are interposed between the vapour generators and are oriented with their outlets towards the surface on which the deposit of oxides is to be formed.

4. Equipment according to Claim 3, characterized in that at least two hollow cathodes aligned in the direction of motion of the substrate, on which the deposit of oxides is to be formed, are disposed between neighbouring vapour generators.

5. Equipment according to at least one of Claims 1 to 4, characterized in that the plasma outlet from the jets is arranged at a level higher than that of the generation of the aluminium vapour.

6. Equipment according to at least one of Claims 1 to 4, characterized in that the ionizing jets comprise a chamber with an outlet of small and lengthened cross-section, whose wall comprises the cathode.

7. Continuous evaporation system with plasma-assisted oxidation for the vacuum deposition of metal oxides on plastic films, the whole as described above and shown by way of example in the attached drawing.
